(19) Europäisches Patentamt

European Patent Office

Office européen des brevets

(11) **EP 1 016 930 A1**

(12) **EUROPEAN PATENT APPLICATION**

(43) Date of publication:
**05.07.2000 Bulletin 2000/27**

(51) Int. Cl.⁷: **G03F 7/09**

(21) Application number: **99124737.0**

(22) Date of filing: **13.12.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **28.12.1998 US 221092**

(71) Applicant:
**Infineon Technologies North America Corp.
San Jose, CA 95112-6000 (US)**

(72) Inventors:
- **Zhijian, Lu
  Poughkeepsie, NY 12603 (US)**
- **Xiaoming, Yin
  Hopewell Junction, NY 12533 (US)**

(74) Representative:
**Patentanwälte
Westphal, Mussgnug & Partner
Waldstrasse 33
78048 Villingen-Schwenningen (DE)**

(54) **Bottom antireflective layer operating in destructive interference and absorption modes**

(57)     Improved CD control is achieved with a ARC that combines absorption and destructive interference properties to reduce reflectance in the resist.

## Description

### Field of the Invention

The invention relates generally to integrated circuit fabrication and more particularly to the improving CD control during patterning.

### Background of the Invention

In formation of semiconductor integrated circuits (ICs), features are formed on a substrate. These features, for example, correspond to devices such as transistors, capacitors, and resistors. These devices are then interconnected to achieve a desired electrical function.

To form the devices, layers are repeatedly deposited on the substrate and patterned as desired. Lithographic techniques are used to pattern the device layer or layers. Such techniques use an exposure source to project a light image from a mask onto a photoresist (resist) layer formed on the surface of the substrate. The light illuminates the resist layer, exposing it with the desired pattern. Depending on whether a positive or negative tone resist is used, the exposed or unexposed portions of the resist layer are removed. The portions not protected by the resist are then, for example, etched to form the features in the substrate.

The dimensions of the features depend on the resolution capability of the lithographic systems. The minimum feature size (F) achieved by a given generation of lithographic systems is referred to as the lithographic groundrule (GR). Critical dimension (CD) is defined as the minimum feature size that must be controlled. This includes, for example, linewidths, spacings, and contact widths.

Due to the variations of light into the resist layer, variations in CD occur. Controlling the variations in CD (CD control) becomes a critical issue, particularly with aggressively shrinking GRs, (e.g., 0.25 microns or below). CD control is facilitated by the use of an antireflective coating (ARC) beneath the resist to reduce reflectance variations into the resist caused by under-lying layers.

The ARC can be used in one of two operational modes to prevent reflectance variations into the resist. The first mode is absorption and the second mode is destructive interference.

In the absorption mode, the ARC absorbs light passing through it. In this manner, scattering light is minimized to avoid exposing the resist undesirably. The ARC should have a suitable extinction coefficient (k) and thickness to absorb the light completely. The k and thickness needed to absorb the light completely vary depending on the wavelength of the exposure source. A higher k would require a thinner ARC layer to absorb completely a given amount of light at a given wavelength. Conversely, a lower k would require a thicker ARC layer to absorb completely the given amount of light at the given wavelength. For example, a k of about 0.5 is requires an ARC thickness of about 1000 Å to fully absorb light at 248 nanometers (nm).

In the destructive interference mode, the reflectance caused by the interface at the bottom surface of the ARC is shifted out of phase with respect to the phase of the reflectance caused by the interface at the top surface of the ARC. By shifting the reflectances appropriately out of phase with respect to each other, they are cancelled out (destructive cancellation).

Conventionally, various organic and inorganic ARCs are used. Organic ARCs include, for example, compounds presently marketed as AR2 and AR3 by Shipley Company. Inorganic ARCs include, for example, silicon nitride, silicon oxynitride, hydrogenated silicon oxynitride, titanium nitride, amorphous silicon, silicon carbide, and amorphous carbon.

Organic ARCs are usually deposited by a spin-on process. Organic ARCs have a relatively fixed refractive index for a given ARC polymer system and dye loading. Different organic ARCs may have different refractive indices. To reduce reflectance at the ARC/resist interface, it is desirable to match the refractive index of the organic ARC with that of the resist, particularly when using ARC in the absorption mode. Since organic ARCs have a relatively fixed refractive index, they are usually used only in the absorption mode when there are significant substrate film thickness variations.

Typically the film stack beneath the ARC have significant thickness variations due to processing such as, for example, film deposition or chemical mechanical polish (CMP). To suppress the effects caused by the thickness variations, a thicker organic ARC is required. The use of a thicker organic ARC in turn requires a thicker resist to sufficiently serve as an etch mask during the ARC open process. The thicker resist leads to a degradation in the depth-of-focus, particularly at smaller GRs (e.g., 0.25 μm or less), resulting in a narrowing of the process window. This has made the use of organic ARCs less attractive for processes at GRs of, for example, 0.25 μm or less.

Inorganic ARCs, on the other hand, have become more popular since they don't have any of the disadvantages associated with organic ARCs. Additionally, inorganic ARCs possess certain advantages such as tunable properties, low defect levels, good conformality, and high etch selectivity to resist.

Inorganic ARCs, although can be used in either mode, are preferably used in the destructive interference mode. This is because inorganic ARCs having a sufficiently high k to operate in the absorption mode usually process a refractive index that does not match the refractive index of the resist. At the smaller GRs, standing waves created by the mismatch in the refractive indices become more pronounced, undesirably resulting in pattern degradation.

To produce destructive cancellation when operating in the destructive interference mode, the inorganic ARC is ideally formed on opaque materials or on very uniform transparent materials. In the case where a transparent material such as silicate glass is underneath the inorganic ARC, the thickness variations of the transparent material creates non-uniformities in the intensities of the reflectances. This makes it difficult to take advantage of the destructive interference effect.

The limitations imposed by the destructive interference mode create some difficulties in providing inorganic ARC process with good CD control since the layers below are usually composed of transparent materials, such as silicate glass, that have large thickness variations. Additionally, inorganic ARCs can, in some cases, contaminate the resist (resist poisoning) above. A cap layer such as silicon oxide ($SiO_2$) may be required to avoid resist poisoning. The mismatch in refractive indices between the resist and the cap layer creates standing wave effects in the resist, adversely impacting CD control.

From the foregoing discussion, it is desirable to provide an ARC layer that results in improved CD control.

## Description of the Drawings

Fig. 1 shows an illustrative embodiment of the invention;
Fig. 2 shows a plot indicating the minimum of reflectance; and
Fig. 3 shows a plot indicating the minimum of reflectance.

## Summary of the Invention

The invention relates to improved CD control in lithography. In one embodiment, improved CD control is achieved by using a multi-layered ARC stack. The multi-layered ARC stack comprises first and second ARC layers operating in absorption and destructive interference mode. In one embodiment, the first ARC layer operates in the absorption mode and the second ARC layer operates in the destructive interference mode to reduce reflectivity in the resist, thereby improving CD control.

## Description of the Invention

The invention relates to semiconductor processing. In particular, the invention relates to improved CD control, thereby producing a wider lithographic process window. In accordance with the invention, improved CD control is achieved by providing a multi-layer ARC stack that combines the absorption and destructive interference properties together.

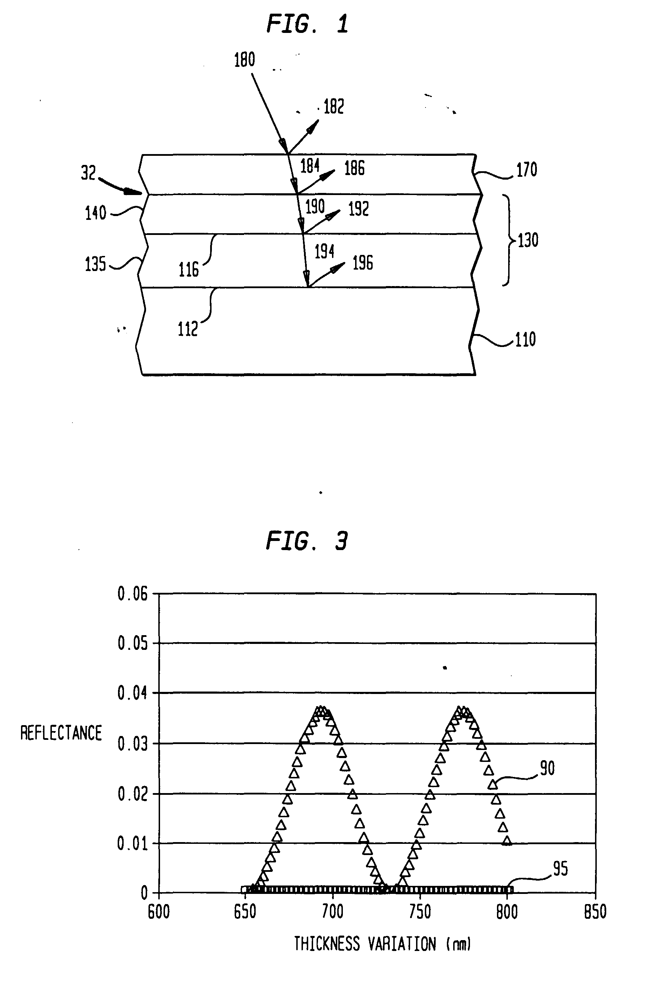

Fig. 1 shows an ARC layer in accordance with one embodiment of the present invention. Illustratively, an ARC layer 130 is provided between the surface of a semiconductor substrate 110 and a resist layer 170. The resist layer comprises, for example, any conventional resist used in lithography. Such resist can either be positive or negative tone resist.

The semiconductor substrate comprises, for example, a silicon wafer. Other types of substrates such as those comprising gallium arsenide, germanium, silicon-on-insulator, or other semiconductor or non-semiconductor materials are also useful. The substrate can be at various stages of the process flow. For example, the substrate can be at the beginning of the process flow or partially processed to include features (not shown). The features are used to form, for example, integrated circuits (ICs) such as dynamic random access memories (DRAMs) or other types of ICs or electromechanical or mechanical devices. For purposes of discussion, the term "substrate" is used to refer to a substrate in general, which can be at any stage in the process flow.

The ARC layer 130 is formed above the substrate. As shown, the ARC layer comprises a multi-layered ARC stack. In one embodiment, the multi-layered ARC stack comprises a first ARC layer 135 and a second ARC layer 140. The second ARC layer 140 is formed over the first ARC layer 135. The first ARC layer 135 is formed over the substrate 110. Above the second ARC layer is formed the resist 170. One of the ARC layers operates in the absorption mode and the other operates in the destructive interference mode to improve CD control. In one embodiment, the first ARC layer operates in the absorption mode and the second ARC layer operates in the destructive interference mode.

The refractive index of the second ARC layer is selected to reduce the reflectivity in the resist. In one embodiment, the refractive index is selected to minimize the reflectivity in the resist. A reduction in reflectivity in the resist is achieved by decreasing the difference in intensities of the reflectances from the interfaces at the lower and upper surfaces of the second ARC layer while keeping or maintaining the two reflectances out-of-phase. As the difference in the intensities of the reflectances approach zero, a reflectivity approaching zero in the resist can be achieved. If the amplitudes of the reflectances are exactly equal to zero, a zero reflectivity in the resist can be achieved. Reducing or minimizing the difference in the intensities of the reflectances can increase or optimize the destructive interference effect.

In one embodiment, the first ARC layer operates in the absorption mode. The first ARC layer comprises an extinction coefficient (k) and suitable thickness to absorb the light therein. In one embodiment, the ARC comprises a k of at least 0.2, preferably at least 0.5, and more preferably at least 1.0. In another embodiment, the ARC comprises a k of at least 1.5.

The thickness of the first ARC layer is chosen to ensure that light therein is sufficiently absorbed for the given k and amount of light. Generally, the thickness is about 5 - 150 nm. Of course the thickness can be varied for different applications depending on different k values.

In one embodiment, the first ARC layer comprises an inorganic ARC operating in the absorption mode. The inorganic ARC comprises a dielectric ARC (DARC). The DARC comprises, for example, silicon oxynitride, hydrogenated silicon oxynitride, silicon carbide, or other dielectric antireflective materials that operate in the absorption mode for the given wavelength of the exposure source. In one embodiment, the DARC comprises silicon oxynitride. The use of inorganic ARCs such as titanium nitride, amorphous silicon, amorphous carbon, or other inorganic antireflective materials that can operate in the absorption mode for the given wavelength of the exposure source is also useful to form the first ARC layer. The inorganic first ARC layer typically has high etch selectivity to the resist and can be tuned to have a high k. This can be advantageous as it enables the use of a relatively thin first ARC layer.

The first ARC layer is formed on the substrate surface using conventional deposition techniques, such as chemical vapor deposition (CVD) or physical vapor deposition. Other deposition techniques are also useful.

The second ARC layer 140 is deposited over the first ARC layer 135. In accordance with one embodiment of the invention, the second ARC 140 layer operates in the destructive interference mode.

The resist is formed over the second ARC layer. Any conventional resist material can be used. The resist is formed by conventional techniques. The thickness of the resist is sufficient to serve as an etch mask for the ARC open process and substrate etch. Typically, the thickness of the resist layer is about 0.2 - 10 $\mu$m.

As described, the multi-layered ARC stack combines absorption and destructive interference properties to reduce reflectance in the resist layer.

Due to a difference in the refractive indices between the materials at the interfaces 132 and 116 formed by the bottom and top surfaces of the second ARC layer, reflectances are produced. These reflectances are passed or reflected through the resist.

The reflectivity that can be achieved in the resist has a direct relationship with the difference in the intensities of the reflectances. As the difference in the intensities of the reflectances becomes smaller, a smaller reflectivity in the resist can be achieved. The acceptable level of reflectivity in the resist can vary depending on design ground rule and process parameters.

In one embodiment, the second ARC layer reduces the difference between the reflectances produced by the interfaces at its upper and lower surfaces such that a reduction in the reflectivity in the resist can be achieved. The difference is reduced to a desired level such that an acceptable reflectivity in the resist can be achieved. Preferably, the second ARC layer minimizes the difference between the reflectances produced by the interfaces at its upper and lower surfaces such that the reflectivity in the resist can be minimized. More preferably, the second ARC layer produces reflectances having about the same intensity such that a reflectivity of about zero can be achieved.

In one embodiment, the second ARC layer comprises an inorganic ARC operating in the destructive interference mode. The inorganic ARC, in one embodiment, comprises a dielectric ARC (DARC). The DARC comprises, for example, silicon nitride, silicon oxynitride, hydrogenated silicon oxynitride, or other dielectric antireflective materials. In one embodiment, the second DARC layer comprises silicon oxynitride. Inorganic ARCs such as titanium nitride, amorphous silicon, amorphous carbon, or other inorganic antireflective materials that operate in the destructive interference mode can be used. Formation of the second ARC layer is achieved using conventional techniques.

In one embodiment, the refractive index of the second inorganic ACT is selected to reduce the difference between the reflectances produced by the interfaces at its upper and lower surfaces such that a reduction in the reflectivity in the resist can be achieved. The refractive index of the second ARC layer is selected to reduce the difference between the reflectances to a desired level such that an acceptable reflectivity in the resist can be achieved. Preferably, the refractive index of the second ARC layer is selected to minimize the difference between the reflectances produced by the interfaces at its upper and lower surfaces such that the reflectivity in the resist can be minimized. More preferably, the refractive index of the second ARC layer is selected to produce reflectances having about the same intensity such that a reflectivity of about zero can be achieved.

The refractive index of the second ARC layer, in accordance with one embodiment of the invention, is dependent upon the refractive indices of the layers above and below. In one embodiment, the second ARC layer comprises a refractive index equal to about:

$$n_x = (n_{x-1}n_R)^{1/2} \qquad\qquad (1)$$

where $n_x$ is the real part of the refractive index of the second ARC layer below the resist layer, $n_{x-1}$ is the real part of the refractive index of the first ARC layer below the second ARC layer, and $n_R$ is the real part of the refractive index of the resist above the second ARC layer. The above equation takes into account only the first order reflection as the second order reflection can be assumed to be negligible.

Forming a second ARC layer having a refractive index in accordance with equation 1 minimizes the difference between the reflectances produced by the interfaces at its upper and lower surfaces. As a result, the reflectances in the resist layer have about the same intensity. This enables a minimum reflectivity in the resist. Keep in mind that the refractive index of the second ARC layer can deviate from equation 1. Depending on design requirements such as acceptable level of reflectivity in the resist, the value of the refractive index of the second ARC layer can deviate somewhat from equation 1.

As k is dependent on n, the k of the second ARC layer is defined when n is selected. Typically, the selected n value of the second ARC results in a relatively low k value. This ensures that the intensity of the reflections into the second ARC layer is not affected or negligibly affected, the second ARC layer comprises a sufficiently low k value. In one embodiment, the second ARC layer comprises a k of less than 0.5 and preferably less than 0.3.

The second ARC layer is configured to operate in the destructive interference mode. By configuring the second ARC layer in the destructive interference mode, light reflected from its top surface into the resist layer and light in the resist that is reflected up through the second ARC are destructively superpositioned. As a result, the lights cancelled each other out.

In one embodiment, the second ARC layer comprises an appropriate thickness to operate in the destructive interference mode. The thickness of the second ARC layer causes the reflectances from the interfaces at its bottom and top surfaces are shifted about 180° with respect to each other to produce destructive cancellation. In one embodiment, the thickness of the second ARC layer is about $\lambda/4n_x$, where $\lambda$ is the wavelength of the exposure source and $n_x$ is the refractive index of the second ARC layer.

By choosing the appropriate refractive index and thickness, the second ARC layer produces reflectances in the resist having about the same intensity and which are shifted out of phase appropriately so as to cancel each other out. This results in improved control of CD during lithography.

In operation, light from the exposure source selectively exposes the resist layer to produce the desired pattern thereon. As a beam of light 180 impinges upon the surface of the resist 170, a portion 182 of the light is reflected from the surface and a portion 184 is transmitted into the resist 170.

As the transmitted portion 184 impacts an interface 132 formed by the resist 170 and the second ARC layer 140, a portion 186 of portion 184 is reflected and a portion 190 is transmitted through the second ARC layer 140.

The portion 190 impacts an interface 116 formed by the second ARC layer 140 and the first ARC layer 135. This impact causes a portion 192 to be reflected and a portion 194 to be transmitted through the first ARC layer 135. As the first ARC layer operates in the absorption mode, either all or substantially all of transmitted portion 194 is absorbed. Any surviving light 196 from portion 194 is reflected off an interface 112 of the first ARC layer 135 and the substrate 110 and is absorbed by the first ARC layer.

The portion 192 travels up through the second ARC layer. The second ARC layer, which is operating in destructive interference mode, does not absorb the portion 192. As such, the portion 192 passes through the interface 132 and into the resist layer.

Due to the refractive index of the second ARC layer chosen in accordance with one embodiment of the invention, the portion 192 passing through the interface and into the resist layer has an intensity which is equal to about the intensity of the reflected portion 186. By selecting the appropriate thickness of the second ARC layer, the reflected portions 186 and 192 are destructively superimposed, canceling or substantially canceling each other out. Thus, improved CD control is achieved by reducing the reflectivity in the resist.

In accordance with another embodiment of the invention, the multi-layered ARC stack 130 comprises first and second ARC layers 135 and 140, respectively, operating in the absorption mode and the destructive interference mode.

As the first ARC layer operates in the absorption mode, it comprises a k and thickness sufficient to absorb the light therein. In one embodiment, the ARC comprises a k of at least 0.2, preferably at least 0.5, and more preferably at least 1.0. In another embodiment, the ARC comprises a k of at least 1.5. The thickness of the first ARC layer is sufficient to ensure that light therein is absorbed for the given k and amount of light. Generally, the thickness is about 5 - 150 nm. Of course the thickness can be varied for different applications and for different k values.

In one embodiment, the first ARC layer comprises an inorganic ARC operating in the absorption mode. The inorganic ARC comprises, for example, a dielectric ARC (DARC). In one embodiment, the DARC comprises silicon oxynitride. Other inorganic antireflective materials that can operate in the absorption mode for the given wavelength of the exposure source is also useful.

Alternatively, the first ARC layer comprises an organic ARC. The first organic ARC layer preferably comprises a higher k value than the second ARC layer. Additionally, antireflective materials that can operate in the absorption mode for the given wavelength of the exposure source and which remain stable during subsequent processes, such as deposition of the second ARC layer and resist, are useful.

The first ARC layer is formed on the substrate surface using conventional deposition techniques, such as chemical vapor deposition (CVD) or physical vapor deposition. Other deposition techniques such as spin-on are also useful, depending on the ARC material.

The second ARC layer 140 below the resist 170 and above the first ARC layer 135 operates in the destructive interference mode. In one embodiment, the second ARC layer comprises an organic ARC. Various types of organic ARCs, such as BARL from Shipley, are useful to form the second ARC layer. The organic ARC layer is deposited by various conventional deposition techniques, such as spin-on coating. The use of an organic ARC as the second ARC layer avoids the potential problem of resist poisoning, eliminating the need to provide a capping layer. Thus, standing wave effects related to the capping layer are avoided. In the case where resist poisoning does not pose a problem, an inorganic ARC can be used as the second ARC layer.

The second ARC layer produces reflectance from the interface 116 at its lower surface and reflectance from the interface 132 at its upper surface. These reflectances are passed or reflected through the resist.

The parameters of the second ARC layer, such as n and thickness, are selected to reduce the difference between the reflectances produced by the interfaces at its upper and lower surfaces such that a reduction in the reflectivity in the resist is achieved by destructive cancellation. The difference is reduced to a desired level such that an acceptable relfectivity in the resist is achieved by destructive cancellation. Preferably, the second ARC layer minimizes the difference between the reflectances produced by the interfaces at its upper and lower surfaces such that the reflectivity in the resist is minimized by destructive cancellation. More preferably, the second ARC layer produces reflectances having about the same intensity such that a reflectivity of about zero can be achieved by destructive cancellation.

The reflectances originating from the interfaces at the lower and upper surfaces of the second ARC layer are dependent on the refractive indices of the first and second ARC layers and the resist. Given this fact, the refractive indices and thicknesses of the ARC layers and resist are variables which can be selected to produce the desired effect from the ARC stack.

Typically, the refractive indices for the first and second ARC layers and thickness of the first ARC layer are selected based on the type of ARC and mode of operation. For example, the first ARC operates in the absorption mode. In the case where the first ARC layer comprises an inorganic ARC, the n is dependent on the k value. Typically, a high k is desirable to enables the use of a thinner ARC. This usually means that k is selected based on the thickness parameters of the first ARC layer. As n is dependent on k, selecting k implicitly defines the n. For organic ARCs, n and k are fixed for a given type of organic ARC. Some flexibility in n exists by choosing the specific type of organic ARC to employ. Also, flexibility exists by using a second ARC layer comprising an inorganic ARC. As for the resist, the n, k, and thickness are also fixed for a given type of resist used. Flexiblity in resist parameters exists by choosing the type of resist to use. For example, n can range from 1.4 - 2.0 depending on the resist type.

For given first and second ARC layers and resist, the thickness of the second ARC layer is selected to cause destructive interference. In one embodiment, the thickness of the second ARC layer is selected to cause the reflectances from the interfaces at the lower and upper surfaces of the second ARC layer to be destructively cancelled. The thickness is selected, in one embodiment, to cause the reflectances from the interfaces at the lower and upper surfaces of the second ARC layer to be about 180° out of phase with respect to each other. In one embodiment, the thickness is selected to cause the reflectance originating from the interface at the lower surface of the second ARC layer to be about 180° out of phase relative to the reflectance originating from the interface at the upper surface of the second ARC layer.

As the difference between the intensities of the reflectances is reduced, the destructive interference created by the second ARC layer reduces reflectivity in the resist.

The intensity of reflected light can be expressed in general as:

$$I = R \times R^*, \tag{1}$$

where I is the intensity, R is the material reflectivity and $R^*$ is the inverse of the material reflectivity. For the multi-ARC stack shown in Fig. 1, the reflectivity in the respective layers as indicated by the subscript having a vertical incidence ($\theta = 90°$) can be expressed as follows:

$$R_{170} = (r_{170} + R_{140})/(1 + r_{170} \times R_{140}); \tag{2}$$

$$R_{140} = (r_{140} + R_{135})/ (1 + r_{140} \times R_{135})\exp(i2k_{140}d_{140}); \qquad (3)$$

$$R_{135} = (r_{135})\exp(i2k_{135}d_{135}); \qquad (4)$$

where d = the thickness of the respective layer, k = wave number of the respective layer, and r = the reflection coefficient of the respective layer. The wave number can be expressed as:

$$k = 2\pi n/\lambda, \qquad (5)$$

where n = the complex refractive index of the respective layer and $\lambda$ = the wavelength of the exposure source. The reflection coefficient of the respective layer can be expressed as:

$$r = (n_x - n)/(n_x + n)= abs(r)\exp(i\phi) \qquad (6)$$

where $n_x$ = the complex refractive index of the layer beneath the respective layer and n = the complex refractive index of the respective layer, and $\phi$ = the phase shift factor due to the non-equal amplitudes of the destructive interference reflectances and is a function of the refractive indices of the ARC layers of the multi-layer ARC stack and resist layer.

As described, the goal is to reduce or minimize reflectivity in the resist layer. From equation 1, the intensity of light (I) in the resist layer can be reduced by reducing the reflectivity therein. The minimum reflectance in the resist layer is achieved as I approaches zero, which is expressed as follows:

$$I = R_{170} \times R_{170}{}^* = min(I) \qquad (7)$$

For a given resist, I is a function of the parameters $d_{140}$, $n_{140}$, $k_{140}$, $n_{135}$, and $k_{135}$. The optimum thickness of the second ARC layer can be obtained through the first order derivative as follows:

$$\delta I/\delta d_{140} = 0 \qquad (8)$$

Setting equation 8 to equal to zero, the minimum or zero reflectivity in the resist is achieved. Solving for $d_{140}$, the thickness of the second ARC layer that produces minimum reflectivity is achieved.

From Equation (8), the following equation can be obtained:

$$4\pi Re(n_{140})d_{140}/\lambda + \phi_{1\,-}\,\phi_2, = m\Pi\ (m = 1,2,...\infty) \qquad (9)$$

where $Re(n_{140})$ = the real part of the refractive index of the second ARC layer, $d_{140}$ = the thickness of the second ARC layer, $\lambda$ = the wavelength of the exposure wavelength, $\phi_1$, $\phi_2$ is defined by equation (6) , $\phi_1$ is between the first ARC and second ARC, $\phi_2$ is between resist and the second ARC, and m represent the occurrence of the minimum reflectivity.

Equation 9 can be solved for the thickness ($d_{140}$) of the second ARC layer that results in about the minimum reflectance in the resist layer since n for a specific organic ARC is fixed. The equation is an attenuated harmonic equation in nature and will produce various thicknesses that result in the minimum reflectance in the resist layer. However, it is desirable to select the smallest value for the thickness of the second DARC layer as this will reduce resist consumption during ARC open process.

Once the thickness of $d_{140}$ is determined, the minimum reflected light at the interface of resist and second ARC can be obtained by setting equation 7 to equal to zero.

$$I = R_{170} \times R_{170}{}^* = 0$$

The optimum refractive index of either the first ARC layer or second ARC layer can be determined. With the aid of, for example, computer simulation, an optimized refractive index can be found.

It can be seen from the above description that a multi-layered ARC stack can be optimized to reduce reflectivity in the resist to improve CD control. For given refractive indices of the different ARC layers and resist, an optimal thickness in the ARC layer operating in destructive interference can be determined to minimize reflectivity in the resist. Furthermore, choosing the particular refractive indices for particular layers can produce an ARC stack having the desired thickness requirements and optical properties.

**Examples**

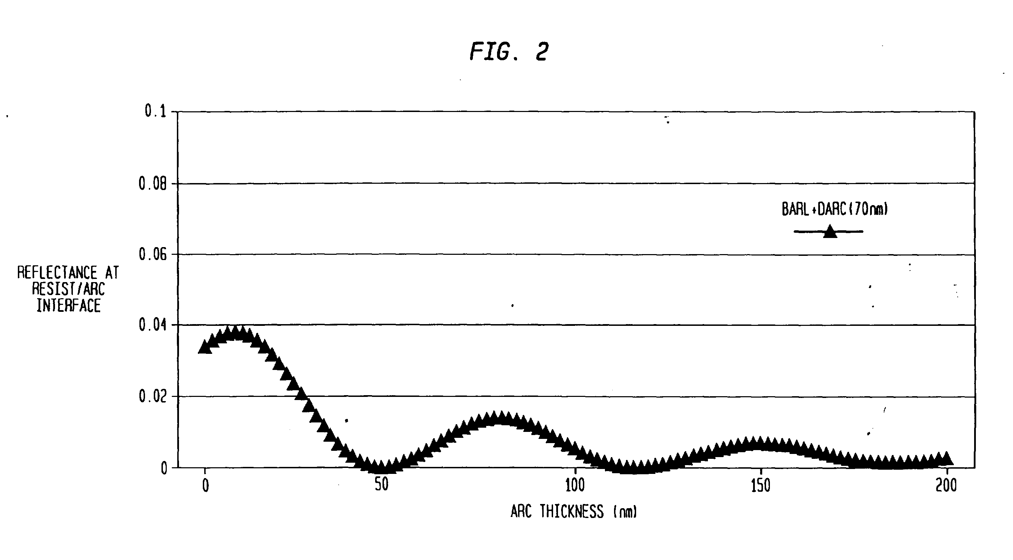

A simulation was performed to determine the reflectance in the resist using an ARC stack in accordance with one embodiment of the invention. The ARC stack included first and second ARC layers. The first ARC layer comprised a 70 nm thick dielectric ARC with n of 2.08 and k of 0.56 operating in the absorption mode. The second ARC layer comprised an inorganic ARC with n of 1.77 and k of 0.24. The reflectance at the resist/ARC interface as a function of the thickness of the second ARC is shown in Fig. 2. From Fig. 2, it can be seen that minimum reflectance at the resist/ARC interface is achieved when the second ARC layer is about 48 nm, 115 nm, and 180 nm thick. As such, the ARC stack can be optimized by selecting the appropriate n and k values for the first and second ARC layers and the thickness of the second ARC layers to reduce or minimize the reflectance in the resist.

A simulation comparing impact of variations in thickness of the underlying layer using a conventional ARC and an ARC stack in accordance with the invention was performed. The conventional ARC comprised a 99 nm thick organic ARC layer with n of 1.77 and k of 0.24. The ARC stack included first and second ARC layers. The first ARC layer comprised a 70 nm thick DARC with n of 2.08 and k of 0.56 operating in the absorption mode and the second layer comprised an 45 nm thick organic ARC with n of 1.77 and k of 0.24. The ARCs were formed on a borosilicate glass (BSG) underlying layer.

Fig. 3 measures the reflectance in the ARC/resist interface as a function of thickness variations in the BSG layer. Line 90 plots the reflectance in the resist using the conventional ARC as a function of BSG thickness and line 95 plots the reflectance in the resist using the ARC stack. From line 90, the conventional ARC produces reflectance that varies with the thickness of the BSG. This is undesirable as this results in poor CD control. Line 95, on the other hand, shows almost zero reflectance at ARC/resist interface. This implies that there are no standing waves in the resist and that the reflectance in the resist is independent of the thickness of the underlying layer, resulting in improved CD control.

While the invention has been particularly shown and described with reference to various embodiments, it will be recognized by those skilled in the art that modifications and changes may be made to the present invention without departing from its scope. The scope of the invention should therefore be determined not with reference to the above description but with reference to the appended claims along with their full scope of equivalents.

**Claims**

1.   In lithography, a method for reducing reflectivity in a resist comprising:

  depositing an antireflective coating (ARC) over a substrate, wherein the ARC operates in the destructive interference and absorption modes; and
  depositing a resist layer over the ARC.

2.   The method of claim 1 wherein depositing the ARC further comprises:

  depositing a first ARC layer, wherein the first ARC layer operates in absorption mode; and
  depositing a second ARC layer, wherein the second ARC layer operates in destructive interference mode.

3.   The method of claim 2 wherein the resist is deposited over the second ARC layer.

4.   The method of claim 3 wherein the first ARC layer is capable of absorbing substantially all light therein from an exposure source for patterning the resist.

5.   The method of claim 4 wherein the first ARC layer comprises a k and thickness capable of absorbing substantially all light therein from an exposure source for patterning the resist.

6.   The method of claim 5 wherein the first ARC layer comprises a k of at least 0.2.

7.   The method of claim 6 wherein the first ARC layer comprises a k of at least 0.5

8.   The method of claim 5 wherein light from an exposure source for patterning the resist results in reflectances produced at interfaces formed by bottom and top surfaces of the second ARC layer, the second ARC layer reduces a difference in intensities of the reflectances to a desired level such that an acceptable reflectivity in the resist can be achieved by destructive interference.

9.   The method of claim 5 wherein light from an exposure source for patterning the resist results in reflectances produced at interfaces formed by bottom and top surfaces of the second ARC layer, the second ARC layer minimizes the difference in intensities of the reflectances such that the reflectivity in the resist can be minimized by destructive interference.

10. The method of claim 5 wherein light from an exposure source for patterning the resist results in reflectances produced at interfaces formed by bottom and top surfaces of the second ARC layer, the second ARC layer causes the intensities of the reflectances to be about equal to each each other such that about a zero reflectivity in the resist can be achieved by destructive interference.

11. The method of claim 10 wherein the first ARC layer comprises an inorganic ARC.

12. The method of claim 10 wherein the first ARC layer comprises a dielectric ARC.

13. The method of claim 10 wherein the first ARC layer comprises an antireflective material that remains stable during subsequent processes.

14. The method of claim 10 wherein the first ARC layer comprises an organic ARC.

15. The method of claim 11, 12, and 14 wherein the second ARC layer comprises a refractive index to reduce the difference in intensities of the reflectances to the desired level.

16. The method of claim 11, 12, and 14 wherein the Second ARC layer comprises a refractive index to minimize the difference in the intensities of the reflectances.

17. The method of claim 11, 12, and 14 wherein the Second ARC layer comprises a refractive index to cause the intensities of the reflectances to be about equal.

18. The method of claim 15 wherein the second ARC layer comprises an inorganic ARC.

19. The method of claim 18 wherein the refractive index of the second ARC layer is dependent of the second ARC layer is dependent on a refractive index of a layer below and a refractive index of a layer above the second ARC layer.

20. The method of claim 19 wherein the refractive index of the second ARC layer is equal to about

$$n_x = (n_{x-1}n_R)^{1/2},$$

where $n_x$ is the real part of the refractive index of the second ARC layer, $n_{x-1}$ is the real part of the refractive index of the layer below the second ARC layer, and $n_R$ is the real part of the refractive index of the layer above the second ARC layer.

21. The method of claim 20 wherein the destructive interference of the second ARC layer causes the reflectances to be out-of-phase with respect to each other to produce destructive cancellation.

22. The method of claim 21 wherein the destructive interference of the second ARC layer causes the reflectances to be about 180° out-of-phase with respect to each other to produce destructive cancellation.

23. The method of claim 22 wherein the thickness of the second ARC layer is selected to produce destructive cancellation of the reflectances.

24. The method of claim 23 wherein the second ARC layer comprises a thickness of about $\lambda/4n_x$, where $\lambda$ is the wavelength of the exposure source and $n_x$ is the refractive index of the second ARC layer.

25. The method of claim 16 wherein the second ARC layer comprises an inorganic ARC.

26. The method of claim 25 wherein the refractive index of the second ARC layer is dependent of the second ARC layer is dependent on a refractive index of a layer below and a refractive index of a layer above the second ARC layer.

27. The method of claim 26 wherein the refractive index of the second ARC layer is equal to about

$$n_x = (n_{x-1}n_R)^{1/2},$$

where $n_x$ is the real part of the refractive index of the second ARC layer, $n_{x-1}$ is the real part of the refractive index of the layer below the second ARC layer, and $n_R$ is the real part of the refractive index of the layer above the second ARC layer.

28. The method of claim 27 wherein the destructive interference of the second ARC layer causes the reflectances to be out-of-phase with respect to each other to produce destructive cancellation.

29. The method of claim 28 wherein the destructive interference of the second ARC layer causes the reflectances to be about 180° out-of -phase with respect to each other to produce destructive cancellation.

30. The method of claim 29 wherein the thickness of the second ARC layer is selected to produce destructive cancellation of the reflectances.

31. The method of claim 30 wherein the second ARC layer comprises a thickness of about $\lambda/4n_x$, where $\lambda$ is the wavelength of the exposure source and $n_x$ is the refractive index of the second ARC layer.

32. The method of claim 17 wherein the second ARC layer comprises an inorganic ARC.

33. The method of claim 32 wherein the refractive index of the second ARC layer is dependent of the second ARC layer is dependent on a refractive index of a layer below and a refractive index of a layer above the second ARC layer.

34. The method of claim 33 wherein the refractive index of the second ARC layer is equal to about

$$n_x = (n_{x-1}n_R)^{1/2},$$

where $n_x$ is the real part of the refractive index of the second ARC layer, $n_{x-1}$ is the real part of the refractive index of the layer below the second ARC layer, and $n_R$ is the real part of the refractive index of the layer above the second ARC layer.

35. The method of claim 34 wherein the destructive interference of the second ARC layer causes the reflectances to be out-of-phase with respect to each other to produce destructive cancellation.

36. The method of claim 35 wherein the destructive interference of the second ARC layer causes the reflectances to be about 180° out-of-phase with respect to each other to produce destructive cancellation.

37. The method of claim 36 wherein the thickness of the second ARC layer is selected to produce destructive cancellation of the reflectances.

38. The method of claim 37 wherein the second ARC layer comprises a thickness of about $\lambda/4n_x$, where $\lambda$ is the wavelength of the exposure source and $n_x$ is the refractive index of the second ARC layer.

39. The method of claims 11, 12, 13, and 14 wherein the second ARC layer comprises an organic ARC.

40. The method of claim 39 wherein the second ARC layer comprises an organic ARC, the organic ARC avoids resist poisoning.

41. The method of claim 40 wherein the second ARC layer comprises a thickness that results in a reflectivity in the resist that is reduced to a desired level.

42. The method of claim 40 wherein the second ARC layer comprises a thickness that results in a minimum reflectivity in the resist.

43. The method of claim 40 wherein the second ARC layer comprises a thickness that results in about a zero reflectivity in the resist.

44. The method of claim 43 wherein the thickness of the second ARC layer is obtained by the first order derivative $\delta I/\delta d$, where I equals to the intensity of light in the resist and d is the thickness of the second ARC layer.

45. The method of claim 44 wherein the thickness of the second ARC layer is obtained by solving for d in the equation $4\pi \text{Re}(n)d/\lambda - \phi_1 + \phi_2 = m\Pi$ $(m = 1,2,...\infty)$, where n is the refractive index of the second ARC layer and d is the thickness of the second ARC layer.

46. The method of claim 45 wherein m is selected to equal to about 1.

## FIG. 1

## FIG. 3

FIG. 2

REFLECTANCE AT RESIST/ARC INTERFACE

ARC THICKNESS (nm)

BARL+DARC(70nm)

European Patent Office

**EUROPEAN SEARCH REPORT**

Application Number

EP 99 12 4737

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 1998, no. 5, 30 April 1998 (1998-04-30) & JP 10 012534 A (NEC CORPORATION), 16 January 1998 (1998-01-16) * abstract * | 1 | G03F7/09 |
| X | CIRELLI R A ET AL: "A MULTILAYER INORGANIC ANTIREFLECTIVE SYSTEM FOR USE IN 248 NM DEEPULTRAVIOLET LITHOGRAPHY" JOURNAL OF VACUUM SCIENCE AND TECHNOLOGY: PART B,US,AMERICAN INSTITUTE OF PHYSICS. NEW YORK, vol. 14, no. 6, 1 November 1996 (1996-11-01), pages 4229-4233, XP000721153 ISSN: 0734-211X * page 4229, column 1, line 26 - page 4230, column 1, line 30 * | 1 | |
| X | T. TANAKA ET AL.: "a novel antireflective mehtod with gradient photoabsorption for optical lithography" PROCEEDINGS OF THE SPIE - INT. SOC. OPT. ENG., vol. 2726, 15 March 1996 (1996-03-15), pages 573-582, XP000905420 USA | 1-13, 15-38, 40-45 | TECHNICAL FIELDS SEARCHED (Int.Cl.7) G03F |
| Y | * page 575, line 1 - page 576, line 16 * | 14,39 | |
| Y | WO 97 33201 A (HOECHST CELANESE CORP) 12 September 1997 (1997-09-12) * the whole document * | 14,39 | |

The present search report has been drawn up for all claims

| Place of search | Date of completion of the search | Examiner |
|---|---|---|
| THE HAGUE | 10 May 2000 | Haenisch, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 016 930 A1

## ANNEX TO THE EUROPEAN SEARCH REPORT
## ON EUROPEAN PATENT APPLICATION NO.

EP 99 12 4737

This annex lists the patent family members relating to the patent documents cited in the above–mentioned European search report.
The members are as contained in the European Patent Office EDP file on
The European Patent Office is in no way liable for these particulars which are merely given for the purpose of information.

10-05-2000

| Patent document cited in search report | | Publication date | Patent family member(s) | | Publication date |
|---|---|---|---|---|---|
| JP 10012534 | A | 16-01-1998 | JP | 2867964 B | 10-03-1999 |
| WO 9733201 | A | 12-09-1997 | CN | 1213437 A | 07-04-1999 |
| | | | EP | 0885407 A | 23-12-1998 |

EPO FORM P0459

For more details about this annex : see Official Journal of the European Patent Office, No. 12/82

15